# EUROPÄISCHE PATENTSCHRIFT

(11) **EP 3 006 392 B1**
(45) Veröffentlichungstag und Bekanntmachung des Hinweises auf die Patenterteilung: **26.09.2018**
(21) Anmeldenummer: 15189073.8
(22) Anmeldetag: 09.10.2015
(51) Int. Cl.: B67C 3/00, B65B 3/00, H05K 5/02, H05K 5/06

(54) **VORRICHTUNG ZUM BEFÜLLEN EINES BEHÄLTERS MIT EINEM FÜLLPRODUKT**
DEVICE FOR FILLING A CONTAINER WITH A FILL PRODUCT
DISPOSITIF DE REMPLISSAGE D'UN RECIPIENT AVEC UN PRODUIT DE REMPLISSAGE

(30) Priorität: 09.10.2014 DE 102014114641
(43) Veröffentlichungstag der Anmeldung: 13.04.2016
(73) Patentinhaber: Krones AG, 93073 Neutraubling (DE)
(72) Erfinder: Doblinger, Josef, 93073 Neutraubling (DE); Hirschberger, Anton, 93073 Neutraubling (DE); Brey, Christian, 93073 Neutraubling (DE); Angerer, Florian, 93073 Neutraubling (DE); Poeschl, Stefan, 93073 Neutraubling (DE)
(74) Vertreter: Nordmeyer, Philipp Werner

(56) Entgegenhaltungen:
- EP-A1- 2 161 790
- EP-A2- 1 768 475
- DE-A1-102011 006 195
- DE-U1-202008 006 413
- GB-A- 1 189 787
- US-A1- 2008 079 224

## Beschreibung

### Technisches Gebiet

Die vorliegende Erfindung betrifft eine Vorrichtung zum Befüllen eines Behälters mit einem Füllprodukt, bevorzugt in einer Getränkeabfüllanlage, in welcher ein Gehäuse zur Aufnahme eines Elektronikmoduls vorgesehen ist.

### Stand der Technik

Aus dem Stand der Technik sind Getränkeabfüllanlagen bekannt, bei welchen Füllorgane zur Befüllung der zu befüllenden Behälter mit einem Füllprodukt vorgesehen sind, welche mittels elektromechanischer Aktuatoren angesteuert werden. Die elektromechanischen Aktuatoren werden jeweils über Elektronikmodule mit den jeweiligen Steuerspannungen beziehungsweise Steuerströmen versorgt, derart, dass ein vorgegebener Öffnungs- und/oder Schließzustand des jeweiligen Füllventils des Füllorgans erreicht werden kann.

Die Elektronikmodule, welche zur Ansteuerung der elektromechanischen Aktuatoren in den Füllorganen vorgesehen sind, sind üblicherweise in zentralen Schankschränken angeordnet, welche beispielsweise zusammen mit einem Füllerkarussell rotieren oder gegenüber einem rotierenden Füllerkarussell feststehend angeordnet sind. Um die jeweiligen Steuersignale beziehungsweise die Steuer- und/oder Schaltströme an die jeweiligen elektromechanischen Aktuatoren zu übertragen, sind Kabeldurchführungen durch die jeweiligen Wände der Schaltschränke vorgesehen.

Dabei ist es bekannt, einen solchen Schaltschrank mit einem leichten Überdruck zu beaufschlagen, beispielsweise durch Druckluft, um sicherzustellen, dass keine Fluide wie Reinigungsflüssigkeiten, Füllprodukte oder Feuchtigkeit von außen in den Schaltschrank eindringen und die Elektronikmodule beschädigen können.

Die bekannte Lösung eines zentralen Schaltschranks mit dem bekannten Aufbau ist bezüglich der Herstellung der jeweiligen elektrischen Verbindungen aufwändig, da zunächst die jeweiligen Kabel durch die Öffnungen in den zentralen Schaltschränken hindurchgeführt werden müssen und die Elektronikmodule kontaktiert werden müssen, und dann die Kabelführungen abgedichtet werden müssen. Weiterhin erhöht das ständige Beaufschlagen der zentralen Schaltschränke mit Druckluft die Betriebskoten der jeweiligen Getränkeabfüllanlage.

Die GB 1,189,787 A beschreibt eine Vorrichtung zum Füllen von Behältern mit kohlensäurehaltigen Getränken. Die Vorrichtung weist ein Steuergerät auf. Die EP 1 768 475 A2 beschreibt eine elektronische Steuereinheit. Die DE 10 2011 006 195 A1 beschreibt eine modulare elektrische Steckverbinderanordnung.

### Darstellung der Erfindung

Es ist daher eine Aufgabe der vorliegenden Erfindung, eine Vorrichtung zum Befüllen eines Behälters mit einem Füllprodukt anzugeben, welche einen verbesserten Aufbau bereitstellt.

Diese Aufgabe wird durch eine Vorrichtung zum Befüllen eines Behälters mit einem Füllprodukt mit den Merkmalen des Anspruchs 1 gelöst. Vorteilhafte Weiterbildungen ergeben sich aus den Unteransprüchen.

Entsprechend wird eine Vorrichtung zum Befüllen eines Behälters mit einem Füllprodukt in einer Getränkeabfüllanlage vorgeschlagen, umfassend einen elektromechanischen Aktuator eines Füllventils, ein Gehäuse, ein in dem Gehäuse aufgenommenes Elektronikmodul zur Steuerung des elektromechanischen Aktuators, sowie mindestens eine im Gehäuse vorgesehene Öffnung zur Durchführung einer elektrischen Kontaktierung des Elektronikmoduls von außerhalb des Gehäuses. Erfindungsgemäß ist die Öffnung durch eine mit dem Gehäuse verschweißte Steckvorrichtung zur Durchführung der elektrischen Kontaktierung fluiddicht verschlossen. Ferner ist der elektromechanische Aktuator im Gehäuse aufgenommen.

Dadurch, dass die Öffnung in dem Gehäuse durch eine mit dem Gehäuse verschweißte Steckvorrichtung zur Durchführung der elektrischen Kontaktierung fluiddicht verschlossen ist, kann eine einfache Kontaktierung des Elektronikmoduls von außerhalb des Gehäuses erreicht werden. Durch das fluiddichte Verschweißen der Steckvorrichtung mit dem Gehäuse kann weiterhin eine absolut dichte Durchführung der elektrischen Kontaktierung erreicht werden. Wenn das Gehäuse und die Steckvorrichtung aus einem metallischen Material bestehen, kann auf diese Weise weiterhin eine Erdung des Gehäuses über den Stecker erreicht werden, so dass zusätzliche Maßnahmen zur Erdung des Gehäuses nicht notwendig sind. In einem weiteren Ausführungsbeispiel kann auch eine Erdung der Steckvorrichtung und des daran angebrachten Elektronikmoduls über das Gehäuse erreicht werden.

Weiterhin ermöglicht es das Anschweißen der Steckvorrichtung in der Öffnung des Gehäuses, dass die Montage der Getränkeabfüllanlage sowie eine möglicherweise anfallende Wartung beziehungsweise ein Austausch des Gehäuses mit dem Elektronikmodul auf einfache Weise durchgeführt werden können, da die Durchführung von Kabeln durch die Gehäusewandung und das anschließende Kontaktieren des Elektronikmoduls sowie das Abdichten der Durchführung fortfällt. Vielmehr kann die jeweilige elektrische Kontaktierung des Elektronikmoduls von außen durch ein direktes Anschließen einer entsprechenden, zu der am Gehäuse festgeschweißten Steckvorrichtung kompatiblen Steckvorrichtung erreicht werden.

Durch die fluiddichte Abdichtung, welche mittels des Verschweißens der Steckvorrichtung mit dem Gehäuse erreicht wird, kann weiterhin auf ein Beaufschlagen beziehungsweise Überströmen des Gehäuses mit Druckluft verzichtet werden, da eine dichte Abdichtung erreicht wird.

Vorteilhaft weist die durch das Verschweißen erzeugte fluiddichte Abdichtung eine Schweißnaht auf, die durch ein Laserschweißverfahren erzeugt wurde, bevorzugt unter Verwendung eines gepulsten Lasers mit niedriger Leistung. Dadurch erfolgt ein möglichst geringer Wärmeeintrag in die Steckvorrichtung und eine entsprechende Beschädigung der Steckvorrichtung durch Hitze kann vermieden werden. Besonders bevorzugt wird die Schweißnaht im I-Stoß, also eine I-Naht erzeugt. Im Gegensatz zum Kehlstoß ist beim I-Stoß die Wärmeeinbringung und Wärmeableitung besser, da nicht so viel Material im Bereich der Naht angeordnet ist.

Bevorzugt ist die Steckvorrichtung mit dem Elektronikmodul elektrisch verbunden, um eine Kontaktierung des Elektronikmoduls von außen zu ermöglichen.

Besonders bevorzugt ist die Steckvorrichtung mechanisch mit dem Elektronikmodul verbunden und das Elektronikmodul ist über die Steckvorrichtung im Gehäuse gehalten. Damit kann durch die Verschweißung der Steckvorrichtung in der Öffnung des Gehäuses neben der vollständigen fluiddichten Abdichtung des Gehäuses gleichzeitig auch ein Halten des Elektronikmoduls am Gehäuse erreicht werden. Dadurch wird nicht nur eine sichere und fluiddichte Abdichtung des

Gehäuses im Bereich der Durchführung der elektrischen Kontaktierung bereitgestellt, sondern gleichzeitig auch das Elektronikmodul sicher am Gehäuse befestigt und eine Erdung bereitgestellt. Auf weitere Befestigungsmittel zum Befestigen des Elektronikmoduls kann entsprechend verzichtet werden.

Bevorzugt ist die Steckvorrichtung beziehungsweise ein Steckvorrichtungsgehäuse aus dem gleichen Material ausgebildet, wie das Gehäuse zur Aufnahme des Elektronikmoduls. Auf diese Weise kann ein problemloses und sicheres Verschweißen der Steckvorrichtung mit dem Gehäuse erreicht werden. Dabei können das Gehäuse sowie die Steckvorrichtung beispielsweise aus einem Metall, beispielsweise einem Edelstahl, oder einem Kunststoff ausgebildet sein. Weitere vorteilhafte und stoffschlüssig verbindbare Materialien zur Ausbildung eines Gehäuses zur Aufnahme eines Elektronikmoduls sind ebenfalls denkbar.

Eine besonders zuverlässige Abdichtung wird erreicht, wenn die Steckvorrichtung selbst fluiddicht ausgebildet ist.

Bevorzugt umfasst die Steckvorrichtung einen Flansch zur Anlage an einem die Öffnung umgebenden Bereich des Gehäuses, und auf der gegenüberliegenden Seite des Gehäuses ist eine Schweißnaht zur fluiddichten Abdichtung und mechanischen Aufnahme der Steckvorrichtung an dem Gehäuse vorgesehen. So lässt sich auf einfach herzustellende Weise eine mechanisch zuverlässige Verbindung herstellen.

In einer weiteren bevorzugten Ausbildung der Vorrichtung ist ein Füllorgan vorgesehen, welches über einen elektromechanischen Aktuator betätigt wird. Das Gehäuse zur Aufnahme des Elektronikmoduls ist dabei direkt an dem Füllorgan beziehungsweise dem elektromechanischen Aktuator angeordnet. Entsprechend kann durch eine Anordnung eines Gehäuses mit einem entsprechenden Elektronikmodul an jedem Füllorgan einer Getränkeabfüllanlage eine dezentrale Anordnung der Elektronikmodule erreicht werden. Auf einen zentralen Schaltschrank kann entsprechend verzichtet werden beziehungsweise dieser kann kleiner ausgeführt werden. Weiterhin entfällt auf diese Weise auch die aufwändige Verkabelung von dem zentralen Schaltschrank zu den jeweiligen mechanischen Aktuatoren.

Bevorzugt ist das Gehäuse zur Aufnahme des Elektronikmoduls derart als eigenständiges Modul ausgebildet, dass es als Modul mit einem elektromechanischen Aktuator verbunden werden kann, um die Betätigung eines Füllventils in einem Füllorgan zu ermöglichen. Das Gehäuse kann neben dem Elektronikmodul auch einen elektromechanischen Aktuator aufnehmen, so dass das Gehäuse mit dem elektromechanischen Aktuator sowie dem Elektronikmodul an einem Füllorgan, insbesondere einem Füllventil, angeordnet werden kann und entsprechend für eine Betätigung des Füllventils sorgt. Durch den modularen Aufbau wird es ermöglicht, das Gehäuse mit dem Elektronikmodul und eventuell dem elektromechanischen Aktuator als gesamtes Modul auszutauschen und entsprechend bei einem Defekt eines einzelnen Füllorgans durch den Austausch des so ausgebildeten Antriebsmoduls eine Wiederherstellung der Betriebsfähigkeit des Füllorgans auf einfache Weise zu erreichen.

Entsprechend entfällt in einer solchen Ausbildung eine aufwändige Fehlersuche sowie ein aufwändiges Wiederverbinden von Elektronikbausteinen mit elektromechanischen Aktuatoren, so wie es in der herkömmlichen Anordnung mit einem zentralen Schaltschrank notwendig war. Vielmehr kann ein einfaches Anbinden des Antriebsmoduls durch einfaches Zusammenstecken der Steckvorrichtung erreicht werden.

Um einen Ausgleich von mechanischen Spannungen, die beispielsweise durch die Wärmeausdehnung des Gehäuses beziehungsweise des Elektronikmoduls auftreten, zu reduzieren beziehungsweise diese zu kompensieren, ist bevorzugt zwischen der Steckvorrichtung und dem Elektronikmodul ein flexibles Element vorgesehen. Dieses kann beispielsweise dadurch erreicht werden, dass das Elektronikmodul über längere Pins mit der Steckvorrichtung verbunden ist oder eine Verbindung der Steckvorrichtung mit dem Elektronikmodul über ein vorzugsweise kurzes Kabel in dem Gehäuse vorgesehen ist. Das Elektronikmodul ist dann immer noch über die Steckvorrichtung an dem Gehäuse gehalten und benötigt insbesondere keine weiteren Befestigungselemente, um mit dem Gehäuse verbunden zu werden. Die Verbindung beziehungsweise das Halten des Elektronikmoduls findet dann über das flexible Element an der Steckvorrichtung statt, so dass die oben beschriebenen vorteilhaften Wirkungen weiterhin erreicht werden.

### Kurze Beschreibung der Figuren

Bevorzugte weitere Ausführungsformen und Aspekte der vorliegenden Erfindung werden durch die nachfolgende Beschreibung der Figuren näher erläutert. Dabei zeigen:
- Figur 1: eine schematische Schnittdarstellung durch ein Gehäuse zur Aufnahme eines Elektronikmoduls in einem ersten Ausführungsbeispiel;
- Figur 2: eine schematische seitliche Draufsicht auf eine Steckvorrichtung;
- Figur 3: eine schematische perspektivische Darstellung eines Elektronikmoduls und an diesem anzubringenden Steckvorrichtungen;
- Figur 4: das Elektronikmodul der Figur 3 mit daran angebrachten Steckvorrichtungen;
- Figur 5: eine schematische perspektivische Darstellung des Vorgangs des Einsetzens des Elektronikmoduls in ein Gehäuse;
- Figur 6: eine schematische perspektivische Darstellung des Gehäuses mit eingesetzten Steckvorrichtungen, an welchen das Elektronikmodul gehalten ist; und
- Figur 7: eine schematische Schnittdarstellung durch ein ein Elektronikmodul sowie einen elektromechanischen Aktuator umschließendes Gehäuse.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen bezeichnet und auf eine wiederholte Beschreibung dieser Elemente wird in der nachfolgenden Beschreibung teilweise verzichtet, um Redundanzen zu vermeiden.

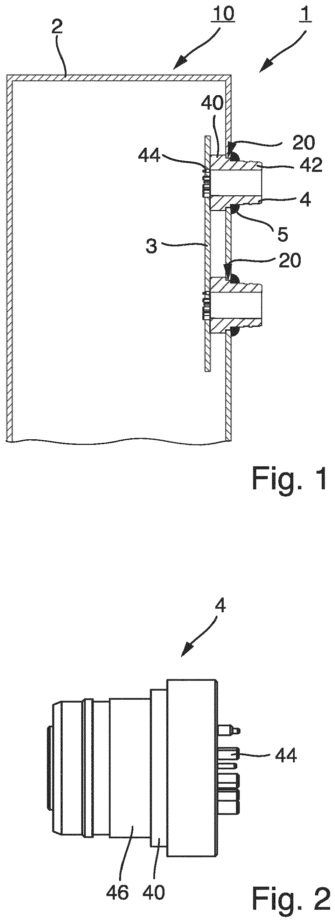

Figur 1 zeigt schematisch einen Teil einer Vorrichtung 1 zum Befüllen eines Behälters mit einem Füllprodukt in Form eines Antriebsmoduls 10 zum Antreiben eines nicht gezeigten Füllventils der Vorrichtung 1.

Die Vorrichtung 1 und insbesondere das Antriebsmodul 10 umfasst ein Gehäuse 2, in welchem ein Elektronikmodul 3 aufgenommen ist. Das Elektronikmodul 3 ist hier schematisch in Form einer Schaltplatine dargestellt. Bei dem Elektronikmodul 3 kann es sich beispielsweise um eine Motorsteuerung für einen elektromechanischen Aktuator handeln, welcher die zum Antrieb des Füllventils benötigten Hübe bereitstellt.

Das Gehäuse 2 ist an sich fluiddicht ausgebildet, weist aber Öffnungen 20 auf, durch welche hindurch das Elektronikmodul 3 von der Außenseite des Gehäuses 2 aus kontaktiert werden kann.

In jeder Öffnung 20 ist eine Steckvorrichtung 4, welche in dem gezeigten Ausführungsbeispiel als Steckerbuchse ausgebildet ist, aufgenommen. Die Steckvorrichtung 4 kann aber auch als Stecker ausgebildet sein - abhängig von dem jeweils in der Vorrichtung 1 verwendeten Anschlusskonzept. Dabei ist die Steckvorrichtung 4 so durch die Öffnung 20 hindurchgeführt, dass sie mit einem Flansch 40 an der inneren Oberfläche des Gehäuses 2 um die Öffnung 20 herum in Anlage kommt. Mit anderen Worten kann die Steckvorrichtung 4 nicht vollständig durch die Öffnung 20 hindurchgeschoben werden, sondern nur, bis der Flansch 40 am Gehäuse 2 anliegt. Der Flansch 40 hat entsprechend einen größeren Durchmesser als die Öffnung 20.

Die Öffnung 20 und die Steckvorrichtung 4 beziehungsweise deren Steckvorrichtungsgehäuse 42 haben bevorzugt einen kreisrunden Querschnitt, so dass die Öffnung 20 als Bohrung ausgebildet sein kann.

Die Steckvorrichtung 4 ist mit dem Gehäuse 2 fluiddicht verschweißt. Entsprechend ist eine Schweißnaht 5 zu erkennen, welche auf der Außenseite des Gehäuses 2 vorgesehen ist und welche sich um die Öffnung 20 und um die Steckvorrichtung 4 herum erstreckt. Damit ist die Steckvorrichtung 4 mechanisch sicher in der Öffnung 20 des Gehäuses 2 gehalten und ist gleichzeitig auch fluiddicht abgedichtet.

Durch die Verschweißung ist die Steckvorrichtung 4 nicht nur fluiddicht und fest in der Öffnung 20 des Gehäuses 2 gehalten, sondern es besteht auch eine materialschlüssige Verbindung zwischen der Steckvorrichtung 4 und dem Gehäuse 2. Die Steckvorrichtung 4 kann sich entsprechend auch durch Vibrationen oder andere mechanische Einflüsse nicht mehr von dem Gehäuse 2 lösen und verschließt dieses fluiddicht. Die Steckvorrichtung 4 selbst ist dabei bereits fluiddicht ausgebildet und wirkt quasi als Stopfen für die Öffnung 20.

Die Steckvorrichtung 4 und insbesondere das Steckvorrichtungsgehäuse 42 ist besonders bevorzugt aus dem gleichen Material ausgebildet, wie das Gehäuse 2. Hierbei kann das Steckvorrichtungsgehäuse 42 beispielsweise aus einem Metall, besonders bevorzugt einem Edelstahl, ausgebildet sein. Das Gehäuse 2 ist entsprechend aus dem gleichen Material ausgebildet. Entsprechend kann die Schweißnaht 5 eine zuverlässige materialschlüssige Verbindung zwischen der Steckvorrichtung 4 und dem Gehäuse 2 herstellen. Alternativ können Gehäuse 2 und Steckvorrichtung 4 auch aus einem Kunststoffmaterial ausgebildet sein.

Alternativ und besonders bevorzugt weist die durch das Verschweißen erzeugte fluiddichte Abdichtung eine Schweißnaht auf, die durch ein Laserschweißverfahren erzeugt wurde, bevorzugt unter Verwendung eines gepulsten Lasers mit niedriger Leistung. Dadurch erfolgt ein möglichst geringer Wärmeeintrag in die Steckvorrichtung und eine entsprechende Beschädigung der Steckvorrichtung durch Hitze kann vermieden werden. Besonders bevorzugt wird die Schweißnaht im I-Stoß, also eine I-Naht erzeugt. Im Gegensatz zum Kehlstoß ist beim I-Stoß die Wärmeeinbringung und Wärmeableitung besser, da nicht so viel Material im Bereich der Naht angeordnet ist.

Das Elektronikmodul 3 in Form der Platine ist über Anschlusspins 44 der Steckvorrichtung 4 elektrisch kontaktiert. Entsprechend kann ein von außerhalb des Gehäuses 2 in die Steckvorrichtung 4 eingeführter Steckkontakt über die Anschlusspins 44 elektrisch mit dem Elektronikmodul 3 kontaktiert werden. Da die Steckvorrichtung 4 aber fluiddicht abschließend in dem Gehäuse 2 aufgenommen ist und weiterhin die Steckvorrichtung 4 selbst auch fluiddicht ausgeführt ist, ist das Innere des Gehäuses 2 zuverlässig fluiddicht gegenüber der Außenseite abgeschirmt.

Das Elektronikmodul 3 wird aber über die Anschlusspins 44 fest an der Steckvorrichtung 4 gehalten. Mit anderen Worten ist die Steckvorrichtung 4 mechanisch so fest mit dem Elektronikmodul 3 verbunden, dass bei der nachfolgenden Verschweißung der Steckvorrichtung 4 mit dem Gehäuse 2 auch das Elektronikmodul 3 mechanisch fest am Gehäuse 2 gehalten ist. Entsprechend ist das Elektronikmodul 3 über die Steckvorrichtung 4 fest mit dem Gehäuse 2 verbunden. Damit ist das Bereitstellen weiterer Befestigungselemente beziehungsweise Befestigungsmittel zum Halten des Elektronikmoduls 3 an dem Gehäuse 2 nicht notwendig und wird einzig über die Steckvorrichtung 4 am Gehäuse 2 gehalten.

In Figur 2 ist schematisch eine Steckvorrichtung 4 gezeigt, welche in eine Öffnung 20 des Gehäuses 2 eingesetzt werden kann. Die Steckvorrichtung 4 weist Anschlusspins 44 auf, welche mit dem entsprechenden Elektronikmodul, das in Figur 2 nicht gezeigt ist, elektrisch kontaktiert werden können. Neben der elektrischen Kontaktierung kann über ein Befestigen des Elektronikmoduls 3 an der Steckvorrichtung 4 auch eine mechanische Verbindung zwischen der Steckvorrichtung und dem Elektronikmodul 3 hergestellt werden. Beispielsweise können die Anschlusspins 44 durch zu ihnen komplementäre Öffnungen im Elektronikmodul 3 hindurchgeführt werden und dann mit dem Elektronikmodul verlötet, verklebt oder gebondet werden. Entsprechend kann das Elektronikmodul 3 elektrisch kontaktiert werden und mechanisch fest an der Steckvorrichtung 4 gehalten werden.

Weiterhin ist der Flansch 40 zu erkennen, welcher in Anlage mit dem Gehäusebereich um die Öffnung 20 des Gehäuses 2 herum kommen kann. Ein Durchführabschnitt 46 des Steckvorrichtungsgehäuses 42 schließt sich an den Flansch 40 an. Dieser Durchführabschnitt 46 wird durch die Öffnung 20 im Gehäuse 2 hindurchgeführt und dient dann, in seiner durch die Öffnung 20 des Gehäuses 2 hindurchgeführten Erstreckung, zur Kontaktierung mit einem von außerhalb des Gehäuses 2 zugeführten Steckers beziehungsweise eines entsprechenden Kabels zum elektrischen Anschluss.

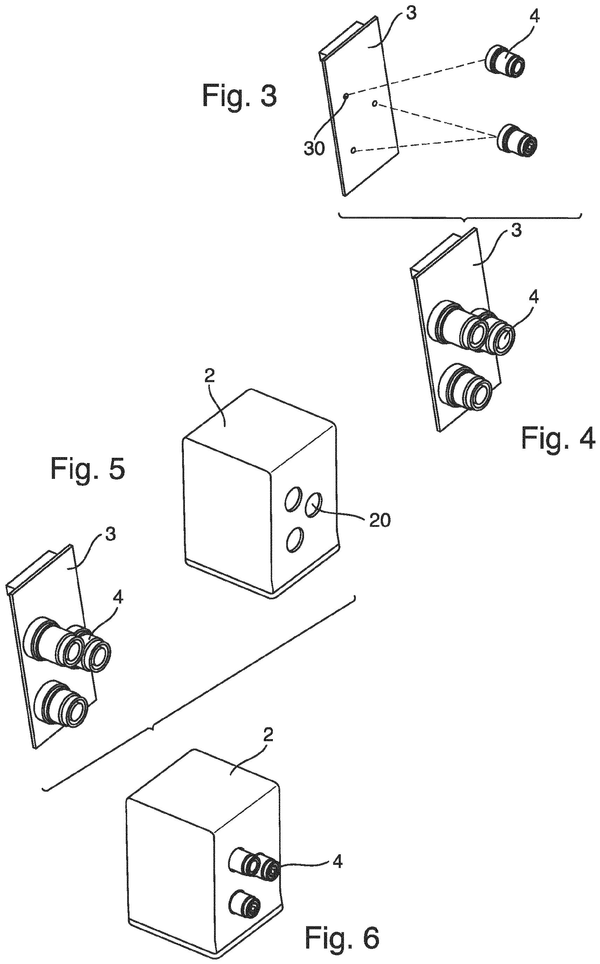

In den Figuren 3 und 4 ist schematisch dargestellt, wie eine Steckvorrichtung 4 mit entsprechenden Ausnehmungen 30 des Elektronikmoduls 3 in Eingriff gebracht werden kann, und an diesen, beispielsweise durch Verlöten oder Verkleben, befestigt und elektrisch kontaktiert werden kann.

In Figur 4 ist entsprechend ein Elektronikmodul 3 mit drei daran angebrachten Steckvorrichtungen 4 gezeigt. Die Steckvorrichtungen 4 sind an dem Elektronikmodul 3 so fest angebracht, dass das Elektronikmodul 3 über die Steckvorrichtungen 4 gehalten werden kann.

In Figur 5 ist schematisch gezeigt, wie das Elektronikmodul 3 mit den jeweiligen Steckvorrichtungen 4 in ein entsprechendes Gehäuse 2 mit darin vorgesehenen Öffnungen 20 eingebracht werden kann. Damit wird zum einen eine abgedichtete Durchführung einer elektrischen Kontaktierung des Elektronikmoduls 3 ermöglicht und zum anderen das Elektronikmodul 3 im Gehäuse 2 gehalten. In Figur 6 ist entsprechend der montierte Zustand des Gehäuses 2 mit den darin angebrachten und verschweißten Steckvorrichtungen 4 gezeigt.

Um einen Ausgleich von mechanischen Spannungen, die beispielsweise durch die Wärmeausdehnung des Gehäuses 2 beziehungsweise des Elektronikmoduls 3 auftreten, zu reduzieren beziehungsweise diese zu kompensieren, ist bevorzugt zwischen der Steckvorrichtung 4 und dem Elektronikmodul 3 ein flexibles Element vorgesehen. Dieses flexible Element kann beispielsweise über längere Pins der Steckvorrichtung 4 oder durch ein kurzes Kabel zwischen der Steckvorrichtung 4 und dem Elektronikmodul 3 vorgesehen sein. Das Elektronikmodul 3 ist dann immer noch über die Steckvorrichtung 4 an dem Gehäuse 2 gehalten und benötigt insbesondere keine weiteren Befestigungselemente, um mit dem Gehäuse 2 verbunden zu werden. Das Halten des Elektronikmoduls 3 findet dann aber über das flexible Element an der Steckvorrichtung 4 statt, so dass mechanische Spannungen reduziert werden können.

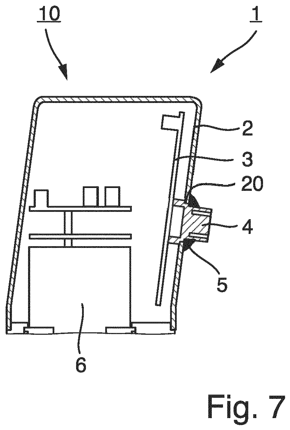

Figur 7 zeigt schematisch einen Querschnitt durch eine Vorrichtung 1, in welcher in einem Gehäuse 2 in einer entsprechenden Öffnung 20 eine Steckvorrichtung 4 über eine Schweißnaht 5 verschweißt ist. An der Steckvorrichtung 4 ist auf deren Rückseite, welche dem Innenraum des Gehäuses 2 zugewendet ist, ein Elektronikmodul 3 in Form einer Platine befestigt. Damit ist sowohl die Durchführung für die elektrische Kontaktierung des Elektronikmoduls 3 bereitgestellt, als auch ein sicheres Halten des Elektronikmoduls 3 erreicht.

In dem Gehäuse 2 ist weiterhin ein elektromechanischer Aktuator 6 aufgenommen, welcher von dem Elektronikmodul 3 angesteuert wird und welcher ein Füllventil so antreiben kann, dass das Füllventil geöffnet und geschlossen werden kann.

Das Gehäuse 2 kann entsprechend als vollständiges Antriebsmodul 10 ausgebildet sein, welches ein in sich abgeschlossenes Antriebsmodul 10 mit einem elektromechanischen Aktuator 6 und ein diesen ansteuerndes Elektronikmodul 3 umfasst. In dem Antriebsmodul 10 kann auch eine Getriebeeinheit vorgesehen sein, welche dann mit dem Ventilstößel des Füllventils gekoppelt werden kann.

Durch die Bereitstellung des Antriebsmoduls 10 in dieser Form ist es möglich, einen Antrieb, welcher sowohl einen elektromechanischen Aktuator 6 als auch die dem elektromechanischen Aktuator 6 zugeordnete Elektronikmodul 3 umfasst, in einem Gehäuse 2 sicher und fluiddicht unterzubringen. Das Antriebsmodul 10 kann entsprechend als Ganzes dezentral an jedem einzelnen Füllorgan vorgesehen sein und einfach über eine zentrale Steuerung angesteuert werden. Die entsprechende Durchführung der Steuerleitungen beziehungsweise der elektrischen Kontaktierung wird dabei über die fluiddichte Anordnung der Steckvorrichtung 4 bewirkt.

In einer Getränkeabfüllanlage kann entsprechend beim Ausfall eines Füllorganes aufgrund von Elektronikproblemen oder Antriebsproblemen das Antriebsmodul 10 als Ganzes ausgetauscht werden, wobei die Kontaktierung einfach dadurch durchgeführt werden kann, dass über die Steckvorrichtung 4 ein entsprechend dazu komplementärer Stecker angeschlossen wird und das Antriebsmodul 10 mit dem Füllorgan beziehungsweise dem Füllventil mechanisch verbunden wird. Entsprechend muss keine aufwändige Fehlersuche durchgeführt werden, sondern das Antriebsmodul 10 wird einfach ausgetauscht, wenn ein Defekt der Elektronik oder des elektromechanischen Aktuators vorliegt. Entsprechend sind komplizierte Fehlersuchen nicht notwendig und der Austausch beziehungsweise die Wartung kann auch von wenig spezialisiertem Bedienpersonal durchgeführt werden.

### Bezugszeichenliste

- 1: Vorrichtung zum Befüllen eines Behälters mit einem Füllprodukt
- 10: Antriebsmodul
- 2: Gehäuse
- 20: Öffnung
- 3: Elektronikmodul
- 30: Ausnehmung<
- 4: Steckvorrichtung
- 40: Flansch
- 42: Steckvorrichtungsgehäuse
- 44: Anschlusspin
- 46: Durchführungsabschnitt
- 5: Schweißnaht
- 6: elektromechanischer Aktuator

## Patentansprüche

1. Vorrichtung (1) zum Befüllen eines Behälters mit einem Füllprodukt in einer Getränkeabfüllanlage, umfassend einen elektromechanischen Aktuator (6) eines Füllventils, ein Gehäuse (2), ein in dem Gehäuse (2) aufgenommenes Elektronikmodul (3) zur Steuerung des elektromechanischen Aktuators (6), sowie mindestens eine im Gehäuse (2) vorgesehene Öffnung (20) zur Durchführung einer elektrischen Kontaktierung des Elektronikmoduls (3) von außerhalb des Gehäuses (2), **dadurch gekennzeichnet, dass** die Öffnung (20) durch eine mit dem Gehäuse (2) verschweißte Steckvorrichtung (4) zur Durchführung der elektrischen Kontaktierung fluiddicht verschlossen ist und der elektromechanische Aktuator (6) in dem Gehäuse (2) aufgenommen ist.

2. Vorrichtung (1) gemäß Anspruch 1, **dadurch gekennzeichnet, dass** die Steckvorrichtung (4) mit dem Elektronikmodul (3) elektrisch verbunden ist.

3. Vorrichtung (1) gemäß Anspruch 1 oder 2, **dadurch gekennzeichnet, dass** die Steckvorrichtung (4) mechanisch mit dem Elektronikmodul (3) verbunden ist und das Elektronikmodul (3) über die Steckvorrichtung (4) im Gehäuse (2) gehalten ist.

4. Vorrichtung (1) gemäß einem der vorstehenden Ansprüche, **dadurch gekennzeichnet, dass** das Material der Steckvorrichtung (4), insbesondere eines Steckvorrichtungsgehäuses (42), dem Material des Gehäuses (2) entspricht, wobei das Material bevorzugt ein Metall, besonders bevorzugt ein Edelstahl, oder ein Kunststoff ist.

5. Vorrichtung (1) gemäß einem der vorstehenden Ansprüche, **dadurch gekennzeichnet, dass** die Steckvorrichtung (4) fluiddicht ausgebildet ist.

6. Vorrichtung (1) gemäß einem der vorstehenden Ansprüche, **dadurch gekennzeichnet, dass** die Steckvorrichtung (4) einen Flansch (40) zur Anlage an einem die Öffnung (20) umgebenden Bereich des Gehäuses (2) umfasst, und auf der gegenüberliegenden Seite des Gehäuses (2) eine Schweißnaht (5) zur fluiddichten Abdichtung und mechanischen Aufnahme der Steckvorrichtung (4) an dem Gehäuse (2) vorgesehen ist.

7. Vorrichtung (1) gemäß einem der vorstehenden Ansprüche, **dadurch gekennzeichnet, dass** das Gehäuse (2) ein Antriebsmodul (10) ausbildet, welches mit einem Füllventil austauschbar in Verbindung bringbar ist.

8. Vorrichtung (1) gemäß einem der vorstehenden Ansprüche, **dadurch gekennzeichnet, dass** mindestens zwei Füllorgane vorgesehen sind, welche jeweils mit einem Antriebsmodul (10) versehen sind.

9. Vorrichtung (1) gemäß einem der vorstehenden Ansprüche, **dadurch gekennzeichnet, dass** die Steckvorrichtung (4) über ein flexibles Element an dem Elektronikmodul (3) angebunden ist.

## Claims

1. Device (1) for filling a container with a fill product in a bottling plant, comprising an electromechanical actuator (6) of a filling valve, a housing (2), an electronics module (3) mounted in the housing (2) for controlling the electromechanical actuator (6), and at least one opening (20) provided in the housing (2) for forming the electrical contact of the electronics module (3) from outside the housing (2),
**characterised in that**
the opening (20) is closed in a fluid-tight manner by a connector (4) welded to the housing (2) for forming the electrical contact and the electromechanical actuator (6) is mounted in the housing (2).

2. Device (1) according to claim 1, **characterised in that** the connector (4) is connected electrically to the electronics module (3).

3. Device (1) according to claim 1 or 2, **characterised in that** the connector (4) is connected mechanically to the electronics module (3) and the electronics module (3) is held in the housing (2) by the connector (4).

4. Device (1) according to any of the preceding claims, **characterised in that** the material of the connector (4), in particular a connector housing (42), corresponds to the material of the housing (2), wherein the material is preferably a metal, more preferably a high-grade steel, or a plastic.

5. Device (1) according to any of the preceding claims, **characterised in that** the connector (4) is designed to be fluid-tight.

6. Device (1) according to any of the preceding claims, **characterised in that** the connector (4) comprises a flange (40) for fitting against an area of the housing (2) surrounding the opening (20), and on the opposite side of the housing (2) a welding seam (5) is provided for the fluid-tight seal and for receiving the connector (4) mechanically on the housing (2).

7. Device (1) according to any of the preceding claims, **characterised in that** the housing (2) forms a drive module (10) which can be brought exchangeably into connection with a filling valve.

8. Device (1) according to any of the preceding claims, **characterised in that** at least two filling elements are provided which are each provided with a drive module (10).

9. Device (1) according to any of the preceding claims, **characterised in that** the connector (4) is attached via a flexible element to the electronics module (3).

## Revendications

1. Dispositif (1) servant à remplir un contenant avec un produit de remplissage dans une installation de transvasement de boissons, comprenant un actionneur électromécanique (6) d'une vanne de remplissage, un boîtier (2), un module électronique (3) logé dans le boîtier (2), servant à commander l'actionneur électromécanique (6), ainsi qu'au moins une ouverture (20) prévue dans le boîtier (2), servant à établir un contact électrique avec le module électronique (3) depuis l'extérieur du boîtier (2),
**caractérisé en ce que**
l'ouverture (20) est fermée de manière étanche aux fluides par un dispositif d'enfichage (4) soudé au boîtier (2) servant à établir un contact électrique, et l'actionneur électromécanique (6) est logé dans le boîtier (2).

2. Dispositif (1) selon la revendication 1, **caractérisé en ce que** le dispositif d'enfichage (4) est relié de manière électrique au module électronique (3).

3. Dispositif (1) selon la revendication 1 ou 2, **caractérisé en ce que** le dispositif d'enfichage (4) est relié de manière mécanique au module électronique (3), et le module électronique (3) est maintenu dans le boîtier (2) par l'intermédiaire du dispositif d'enfichage (4).

4. Dispositif (1) selon l'une quelconque des revendications précédentes, **caractérisé en ce que** le matériau du dispositif d'enfichage (4), en particulier d'un boîtier de dispositif d'enfichage (42), correspond au matériau du boîtier (2), dans lequel le matériau est de manière préférée un métal, de manière particulièrement préférée un acier inoxydable, ou une matière plastique.

5. Dispositif (1) selon l'une quelconque des revendications précédentes, **caractérisé en ce que** le dispositif d'enfichage (4) est réalisé de manière étanche aux fluides.

6. Dispositif (1) selon l'une quelconque des revendications précédentes, **caractérisé en ce que** le dispositif d'enfichage (4) comprend une bride (40) destinée à venir en appui au niveau d'une zone, entourant l'ouverture (20), du boîtier (2), et un cordon de soudure (5) servant à étanchéifier de manière étanche aux fluides et à loger de manière mécanique le dispositif d'enfichage (4) au niveau du boîtier (2) est prévu sur le côté opposé du boîtier (2).

7. Dispositif (1) selon l'une quelconque des revendications précédentes, **caractérisé en ce que** le boîtier (2) réalise un module d'entraînement (10), qui peut être amené en liaison de manière interchangeable avec une vanne de remplissage.

8. Dispositif (1) selon l'une quelconque des revendications précédentes, **caractérisé en ce que** sont prévus au moins deux organes de remplissage, lesquels sont pourvus respectivement d'un module d'entraînement (10).

9. Dispositif (1) selon l'une quelconque des revendications précédentes, **caractérisé en ce que** le dispositif d'enfichage (4) est attaché au module électronique (3) par l'intermédiaire d'un élément flexible.
